# EUROPEAN PATENT APPLICATION

(11) **EP 4 550 959 A1**
(43) Date of publication of application: **07.05.2025**
(21) Application number: 24783550.7
(22) Date of filing: 20.09.2024
(51) Int. Cl.: H05K 7/20, H04M 1/02, D06M 10/02, D06M 11/83, D06M 15/643, D06M 101/40

(54) **HEAT DISSIPATION MEMBER, METHOD FOR MANUFACTURING HEAT DISSIPATION MEMBER, AND ELECTRONIC DEVICE INCLUDING HEAT DISSIPATION MEMBER**

(30) Priority: 21.09.2023 KR 20230126304
(71) Applicant: Samsung Electronics Co., Ltd, Suwon-si, Gyeonggi-do 16677 (KR); Research & Business Foundation SungKyunKwan University, Gyeonggi-do 16419 (KR)
(72) Inventor: LEE, Junghoon, Suwon-si Gyeonggi-do 16677 (KR); KIM, Youngsan, Suwon-si Gyeonggi-do 16677 (KR); MOON, Hongki, Suwon-si Gyeonggi-do 16677 (KR); WON, Kyuyeon, Suwon-si Gyeonggi-do 16419 (KR); LEE, Changgu, Suwon-si Gyeonggi-do 16419 (KR); LIM, Hyunjong, Suwon-si Gyeonggi-do 16419 (KR)
(74) Representative: HGF
(86) International application number: PCT/KR2024/014204
(87) International publication number: WO 2025/063743

(57) **Abstract**

According to various embodiments, the electronic device may include a first structure, a second structure spaced apart from the first structure, and a heat dissipation member thermally connected to the first structure and the second structure. The heat dissipation member may include carbon fibers aligned to be at least partially oriented, thermally conductive wires at least partially thermally connecting the carbon fibers, and a polymer film at least partially coated on the carbon fibers and the thermally conductive wires.

## Description

### [Technical Field]

Embodiments of the present disclosure relate to a heat dissipation member, a method of manufacturing a heat dissipation member, and an electronic device including the heat dissipation member.

### [Background Art]

Electronic devices may include a heat source (e.g., a heat generating element) and a heat generated by the heat source needs to be efficiently dissipated to the surroundings through a heat dissipation member. The heat dissipation member may require a flexible structure that can respond to the operation methods of electronic devices (e.g., foldable electronic devices, slidable electronic devices, and/or rollable electronic devices) that operate in various ways.

The above information may be provided as related information only to assist in an understanding of the disclosure. No determination has been made, and no assertion is made, as to whether any of the above might be applicable as a prior art with regard to the disclosure.

### [Disclosure of Invention]

### [Technical Problem]

Electronic devices are becoming increasingly slimmer to satisfy consumers' purchasing desires as the functional gap between different manufacturers is significantly reduced, and they are being improved to increase the rigidity of electronic devices, enhance design aspects, and differentiate their functional elements. These electronic devices are moving away from a uniform rectangular shape to a variety of shapes. For example, electronic devices may have a deformable structure that allows them to be portable and, when in use, have a large screen display. The deformable electronic device may include a deformable foldable electronic device and/or a rollable electronic device, where the display area of the flexible display is variable.

The deformable electronic device may include a heat source (e.g., a processor) and the heat generated by the heat source may be rapidly dissipated to the surroundings through a heat dissipation member disposed inside the electronic device, thereby reducing discomfort to the user and helping to improve the performance of the electronic device. Typically, these heat dissipation members are placed under the flexible display and the heat collected by the heat dissipation members can quickly spread to the surroundings.

Heat dissipation members based on carbon (e.g., graphite sheets), which are generally known as materials with excellent thermal conductivity, do not have stretching properties and may break or tear when bent (or folded) together with a flexible display. In addition, the heat dissipation member, when bent, may remain bent permanently deforming without self-resilience. Accordingly, the electronic device may require space to accommodate such a bent shape, and such space may be counterproductive to the slimming of the electronic device.

Various embodiments of the present disclosure may provide a heat dissipation member configured to have stretching properties, a method of manufacturing the heat dissipation member, and an electronic device including the heat dissipation member.

Various embodiments may provide a heat dissipation member configured to have elastic resiliency to flexibly respond to bending and/or folding operations of a flexible display, a method of manufacturing the heat dissipation member, and an electronic device including the heat dissipation member.

Various embodiments may provide a heat dissipation member configured to have excellent thermal conductivity, methods of manufacturing the heat dissipation member, and an electronic device including the heat dissipation member.

However, the problem to be solved by the present disclosure is not limited to the above-mentioned problems and may be expanded in various ways without departing from the spirit and scope of the present disclosure.

### [Solution to Problem]

According to various embodiments, a heat dissipation member is provided, comprising: carbon fibers aligned to be at least partially oriented; thermally conductive wires configured to thermally interconnect at least some of the carbon fibers; and a polymer film configured to at least partially coat the carbon fibers and the thermally conductive wires.

According to various embodiments, an electronic device is provided comprising: a heat dissipation member comprising carbon fibers aligned to be at least partially oriented, thermally conductive wires configured to thermally interconnect at least some of the carbon fibers, and a polymer film configured to at least partially coat the carbon fibers and the thermally conductive wires; a first structure; and a second structure spaced apart from the first structure; wherein the heat dissipation member is configured to thermally connect the first structure and the second structure.

According to various embodiments, a method of manufacturing a heat dissipation member is provided, the method comprising: introducing a composite composition containing carbon fibers, thermally conductive wires, and elastomers into an organic solvent, followed by stirring; introducing the stirred composite composition into ultrapure water, followed by water phase alignment; and drying the water phase aligned composite composition and then coating the dried water phase aligned composite composition with an elastic polymer.

According to various embodiments, an electronic device may include a first structure, a second structure spaced apart from the first structure, and a heat dissipation member thermally connected to the first structure and the second structure. The heat dissipation member may include carbon fibers aligned to be at least partially oriented, thermally conductive wires at least partially thermally connecting the carbon fibers, and a polymer film at least partially coated on the carbon fibers and the thermally conductive wires.

According to various embodiments, a heat dissipation member may include carbon fibers aligned to be at least partially oriented, thermally conductive wires at least partially thermally connecting the carbon fibers, and a polymer film at least partially coated on the carbon fibers and the thermally conductive wires.

According to various embodiments, a method of manufacturing a heat dissipation member may include: introducing a composite composition containing carbon fibers, thermally conductive wires, and an elastomer into an organic solvent, followed by stirring; introducing a mixed solution containing the stirred composite composition into ultrapure water, followed by water phase alignment; drying the water phase aligned composite composition; and coating the elastic polymer.

### [Advantageous Effects of Invention]

A heat dissipation member according to exemplary embodiments of the present disclosure may have a high thermal conductivity through a composite composition containing a carbon fiber, a thermally conductive wire and an elastomer, and may be composed of a heat-conducting network that is stretchable, so that the placement of the heat dissipation member can be considered and can be flexibly applied to areas requiring deformation or bending, without structural changes that impede the slimming of the electronic device.

In addition, various effects that can be directly or indirectly identified through this document may be provided.

Advantageous effects obtainable from the disclosure may not be limited to the above-mentioned effects, and other effects which are not mentioned may be clearly understood, through the following descriptions, by those skilled in the art to which the disclosure pertains.

### [Brief Description of Drawings]

In relation to the description of the drawings, identical or similar reference numerals may be used for identical or similar components.
FIG. 1A is a front perspective view of an electronic device illustrating a folded state or an unfolded state according to various embodiments of the present disclosure.
FIG. 1B is a plan view illustrating the front surface of an electronic device in an unfolded state according to various embodiments of the present disclosure.
FIG. 1C is a plan view illustrating a rear surface of an electronic device in an unfolded state according to various embodiments of the present disclosure.
FIG. 2A is a perspective view of an electronic device illustrating a folded state according to various embodiments of the present disclosure.
FIG. 2B is a perspective view of an electronic device illustrating an intermediate state according to various embodiments of the present disclosure.
FIG. 3 is an exploded perspective view of a flexible display according to various embodiments of the present disclosure.
FIG. 4 is a partial cross-sectional view of an electronic device viewed along the line 4-4 of FIG. 1A according to various embodiments of the present disclosure.
FIG. 5 is a process diagram illustrating a sequence for manufacturing a heat dissipation member according to various embodiments of the present disclosure.
FIG. 6A is an enlarged photograph of a carbon fiber according to various embodiments of the present disclosure.
FIG. 6B is an enlarged photograph of a carbon nanotube according to various embodiments of the present disclosure.
FIG. 6C is an enlarged photograph of stirred carbon fibers and carbon nanotubes according to various embodiments of the present disclosure.
FIG. 6D is an enlarged photograph of a connection structure between carbon fibers through carbon nanotubes according to various embodiments of the present disclosure.
FIG. 6E is a photograph of a state in which a composite composition is aligned through a surfactant according to various embodiments of the present disclosure.
FIG. 6F is an enlarged photograph of a connection structure between carbon fibers through silver nanowires according to various embodiments of the present disclosure.
FIG. 7A is a plan view of an electronic device in a slide-in state according to various embodiments of the present disclosure.
FIG. 7B is a cross-sectional view of an electronic device viewed along the line 7b-7b of FIG. 7A according to various embodiments of the present disclosure.
FIG. 7C is a plan view of an electronic device in a slide-out state according to various embodiments of the present disclosure.
FIG. 7D is a cross-sectional view of an electronic device viewed along the line 7d-7d of FIG. 7C according to various embodiments of the present disclosure.
FIG. 7E is a schematic diagram of a flexible display with a heat dissipation member disposed according to various embodiments of the present disclosure.

### [Mode for the Invention]

The following description with reference to the accompanying drawings is provided to assist in a comprehensive understanding of various embodiments of the disclosure as defined by the claims and their equivalents. It includes various specific detail to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and configurations may be omitted for clarity and conciseness.

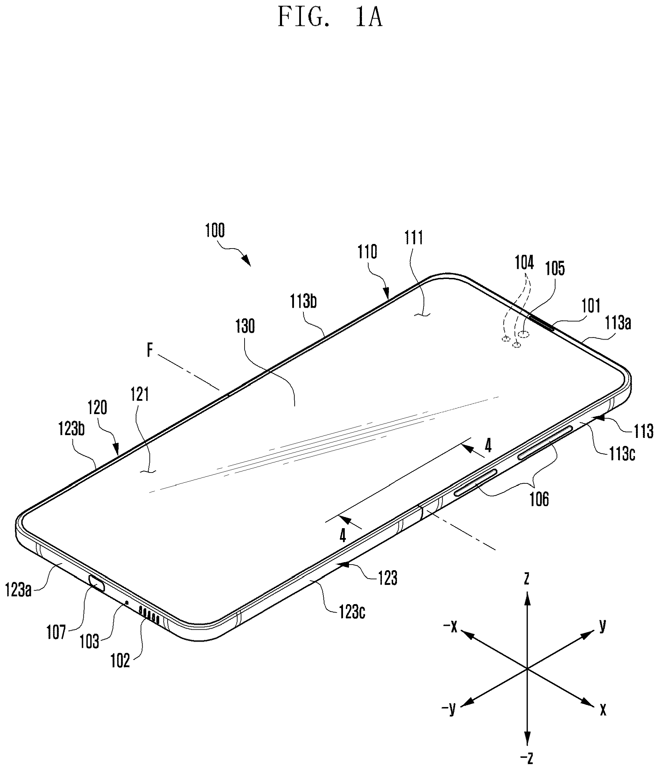

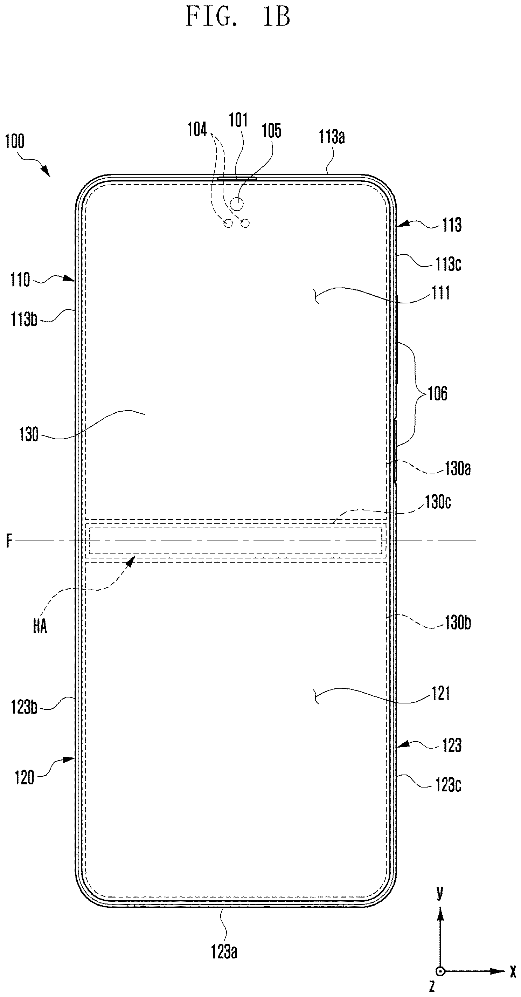

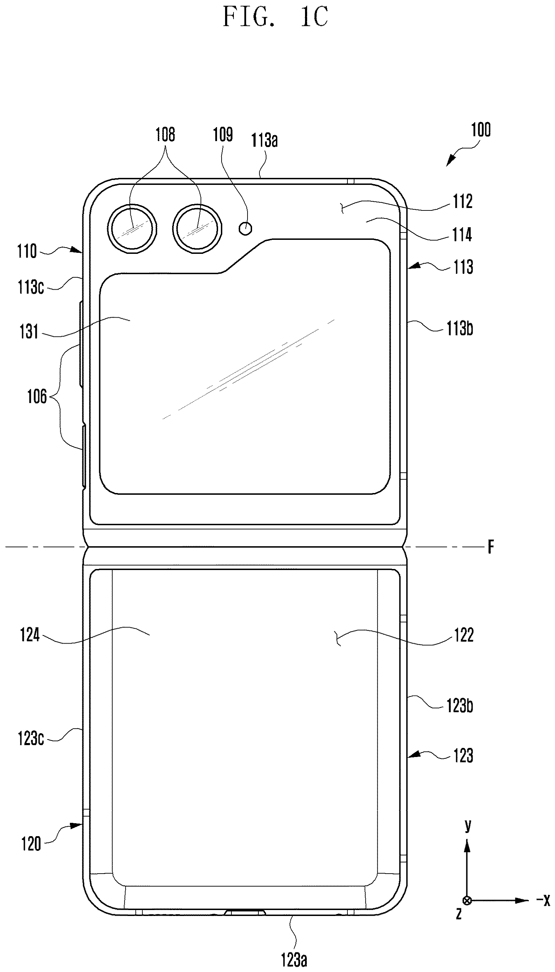

FIG. 1A is a perspective view of an electronic device illustrating a flat state (or unfolded state) of the electronic device according to an embodiment of the disclosure. FIG. 1B is a plan view illustrating a front surface of an electronic device in an unfolded state according to an embodiment of the disclosure. FIG. 1C is a plan view illustrating a rear surface of an electronic device in an unfolded state according to an embodiment of the disclosure.

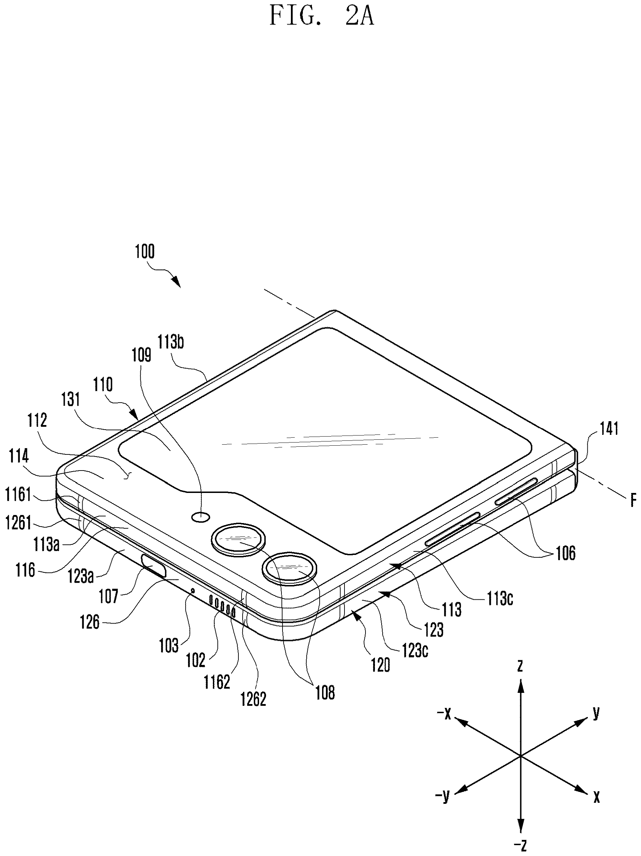

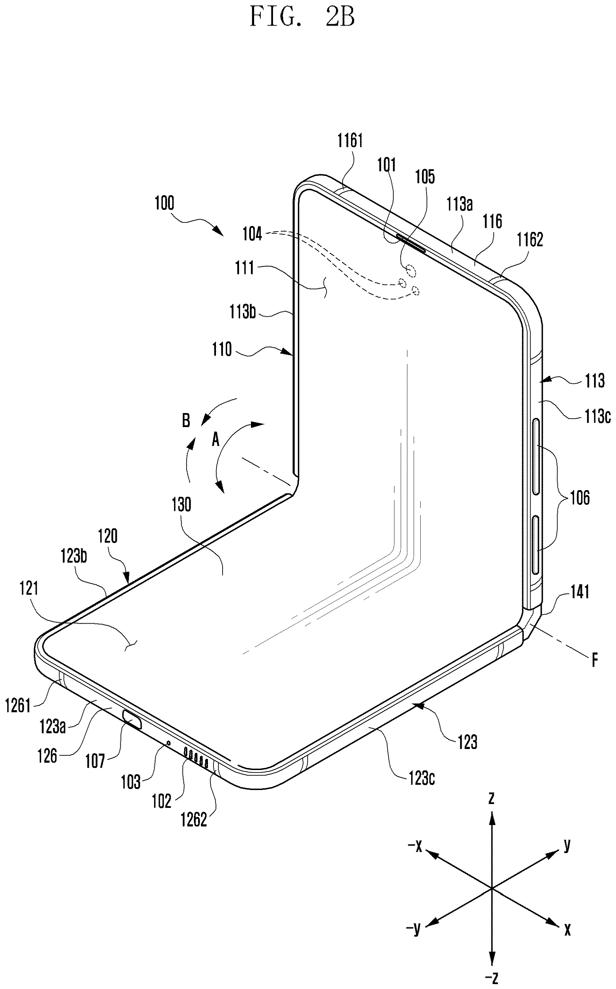

FIG. 2A is a perspective view of an electronic device illustrating a folded state of the electronic device according to an embodiment of the disclosure. FIG. 2B is a perspective view of an electronic device illustrating an intermediate state of the electronic device according to an embodiment of the disclosure.

Referring to FIGS. 1A to 1C, 2A, and 2B, an electronic device 100 may include first and second housings 110 and 120 (e.g., a foldable housing structure) that are connected so that they can be folded with respect to each other based on a hinge (or hinge device) (e.g., the hinge device HA of FIG.1B). In one embodiment, the first housing 110, the second housing 120 and the hinge device HA may include foldable housing (e.g., housing, foldable housing structure or housing structure). In one embodiment, the hinge device (HA) may be disposed in the direction of the X axis or in the direction of the Y axis. In one embodiment, the electronic device 100 may include a first display 130 (e.g., a flexible display, a foldable display, or a main display) disposed in an area (e.g., recess) formed by the first and second housings 110 and 120. In one embodiment, the first housing 110 and the second housing 120 may be disposed on opposite sides centered on the folding axis F and may have a shape that is substantially symmetrical with respect to the folding axis F. In one embodiment, the angle or distance between the first housing 110 and the second housing 120 may vary depending on the state of the electronic device 100. For example, depending on whether the electronic device is in a flat state or an unfolded state, a folded state, or an intermediate state, the first housing 110 and the second housing 120 may have different angles or distances formed from each other.

In one embodiment, the first housing 110 may include a first surface 111 facing the first direction (e.g., the front direction) (z axis direction) and a second surface 112 facing the second direction (i.e., the rear direction) (-z axis direction) opposite the first surface 111 in the unfolded state of the electronic device 100. In one embodiment, the second housing 120, in the unfolded state of electronic device 100, may include a third surface 121 facing the first direction (in the z-axis direction) and a fourth surface 122 facing the second direction (-z axis direction). In one embodiment, in the unfolded state of the electronic device 100, the first surface 111 of the first housing 110 and the third surface 121 of the second housing 120 may face substantially the same first direction (in the direction of the z axis). In one embodiment, in the folded state of the electronic device 100, the first surface 111 of the first housing 110 and the third surface 121 of the second housing 120 may face each other. In one embodiment, in the unfolded state of the electronic device 100, the second surface 112 of the first housing 110 and the fourth surface 122 of the second housing 120 may face substantially the same second direction (- z axis direction). In one embodiment, in the folded state of the electronic device 100, the second surface 112 of the first housing and the fourth surface 122 of the second housing 120 may face opposite each other. For example, in the folded state of electronic device 100, the second surface 112 may face the first direction (in the z axis), and the fourth surface 122 may face the second direction (-z axis direction). In this case, the first display 130 may not be visible from the outside (in folding mode). In one embodiment, the electronic device 100 may be folded so that the second surface 112 of the first housing 110 and the fourth surface 122 of the second housing 120 face each other. In this case, the first display 130 may be disposed to be viewed from the outside (out-folding).

According to various embodiments, the first housing 110 (e.g., the first housing structure) may include a first lateral member 113 that at least partially forms an exterior of the electronic device 100, and a first rear surface cover 114 (e.g., a first rear cover) that is coupled to the first lateral member 113 and forms at least portion of the second surface 112 of the electronic device 100. In one embodiment, the first lateral member 113 may include the first side surface 113a, the second side surface 113b extending from one end of the first side surface 113a, and the third side surface 113c extending from the other end of the first side surface 113a. In one embodiment, the first lateral member 113 may be formed into a quadrilateral (e.g., square or rectangular) shape through the first side surface 113a, the second side surface 113b, and the third side surface 113c.

According to various embodiments, the second housing 120 (e.g., the second housing structure) may include a second lateral member 123 that at least partially forms an exterior of the electronic device 100, and a second rear surface cover 124 (e.g., a second rear cover) that is at least partially coupled to the second lateral member 123, and a second lateral member 123 and forms at least portion of the fourth surface 122 of the electronic device 100. In one embodiment, the second lateral member 123 may include the fourth side surface 123a, a fifth side surface 123b extending from one end of the fourth side surface 123a, and the sixth side surface 123c extending from the other end of the fourth side surface 123a. In one embodiment, the second lateral member 123 may be formed into a quadrilateral shape through the fourth side surface 123a, the fifth side surface 123b, and the sixth side surface 123c.

According to various embodiments, the first and second housings 110, 120 are not limited to the illustrated shape and combination, and may be implemented by a combination and/or a coupling of other shapes or parts. In one embodiment, the first lateral member 113 may be integrally formed with the first rear surface cover 114, and the second lateral member 123 may be integrally formed with the second rear surface cover 124.

According to various embodiments, in the unfolded state of the electronic device 100, the second side surface 113b of the first lateral member 113 and the fifth side surface 123b of the second lateral member 123 may be connected without a gap. In one embodiment, in the unfolded state of the electronic device 100, the third side surface 113c of the first lateral member 113 and the sixth side surface 123c of the second lateral member 123 may be connected without a gap. In one embodiment, when electronic device 100 is unfolded, the sum of the lengths of the second side surface 113b and the fifth side surface 123b may be constituted to be longer than the length of the first side surface 113a and/or the fourth side surface 123a. In one embodiment, in the unfolded state of electronic device 100, the sum of the lengths of the third side surface 113c and the sixth side surface 123c may be constituted to be longer than the length of the first side surface 113a and/or the fourth side surface 123a.

Referring to FIGS. 2A and 2B, the first lateral member 113 and/or the second lateral member 123 may be made of metal or polymer injected into the metal. In one embodiment, the first lateral member 113 and/or the second lateral member 123 may also include at least one conductive portion 116 and/or 126 electrically segmented through at least one segmentation portion 1161, 1162 and/or 1261, 1262 formed by the polymer. In such a case, at least one conductive portion 116 and/or 126 may be used as at least portion of an antenna operating in at least one band (e.g., legacy band) specified by an electrical connection with a radio communication circuit contained in electronic device 100.

According to various embodiments, the first rear surface cover 114 and/or the second rear surface cover 124 may be formed by a combination of at least one or at least two of the coated or colored glass, ceramics, polymers, or metals (e.g., aluminum, stainless steel (STS), or magnesium).

According to various embodiments, the first display 130 may be disposed to extend from the first surface 111 of the first housing 110 across the hinge device (HA) to at least a portion of the third surface 121 of the second housing 120. In one embodiment, the first display 130 may substantially include a first area 130a corresponding to the first surface 111, a second area 130b corresponding to the second surface 112, and a third area 130c (e.g., a flexible area or folding area) connecting the first area 130a and the second area 130b.In one embodiment, the third area 130c may be disposed in a position corresponding to the hinge device (HA) as part of the first area 130a and/or the second area 130b. In one embodiment, the electronic device 100 may include a hinge housing 141 (e.g., a hinge cover) supporting a hinge device (HA). In one embodiment, the hinge housing 141 may be exposed to the outside when the electronic device 100 is in the folded state, and may be disposed invisibly from the outside by being inserted into the inner space of the first housing 110 and the inner space of the second housing 120when the electronic device 100 is in the unfolded state.

According to various embodiments, electronic device 100 may include a second display 131 (e.g., a sub display) that is disposed separately from the first display 130. In one embodiment, the second display 131 may be disposed on the second surface 112 of the first housing 110 to be at least partially exposed. In one embodiment, when the electronic device 100 is in a folded state, the second display 131 may display at least portion of the state information of the electronic device 100, replacing at least portion of the display function of the first display 130. In one embodiment, the second display 131 may be disposed so that it can be viewed from the outside through at least portion of the area of the first rear surface cover 114. In one embodiment, the second display 131 may be disposed on the fourth surface 122 of the second housing 120. In such a case, the second display 131 may be disposed so that it can be viewed from the outside through at least portion of the area of the second rear surface cover 124.

According to various embodiments, the electronic device 100 may include at least one of an input device 103 (e.g., microphone), a sound output device 101 and 102, a sensor module 104, a camera device 105 and 108, a keystroke device 106 or a connector port 107. In the illustrated embodiment, the input device 103 (e.g., microphone), the sound output device 101 and 102, the sensor module 104, the camera device 105 and 108, the keystroke device 106 or the connector port 107 are illustrated as holes or circular elements formed in the first housing 110 or second housing 120, but this is illustrative for the purpose of explanation and is not limited thereto. According to various embodiments, input device 103 may include at least one microphone 103 disposed in second housing 120. In one embodiment, input device 103 may include a plurality of microphones 103 that are disposed to detect the direction of sound. In one embodiment, a plurality of microphones 103 may be disposed in appropriate locations in the first housing 110 and/or the second housing 120. In one embodiment, sound output devices 101 and 102 may include at least one speaker 101 and 102. In one embodiment, at least one speaker 101 and 102 may include a call receiver 101 disposed in the first housing 110 and a speaker 102 disposed in the second housing 120. In one embodiment, input device 103, sound output device 101 and 102 and connector port 107 are disposed in a space provided in the first housing 110 and/or second housing 120 of the electronic device 100 and may be exposed to the external environment through at least one hole formed in the first housing 110 and/or second housing 120. In one embodiment, at least one connector port 107 may be used to transmit and receive power and/or data with an external electronic device. In one embodiment, at least one connector port (e.g., an earjack hole) may also accommodate a connector (e.g., an earjack) for transmitting and receiving audio signals with an external electronic device. In one embodiment, holes formed in first housings 110 and/or second housings 120 may be used for input devices 103 and sound output devices 101 and 102. In one embodiment, sound output devices 101 and 102 may also include speakers (e.g., piezo speakers) that are not exposed through holes formed in the first housing 110 and/or second housing 120.

According to various embodiments, the sensor module 104 may generate electrical signals or data values corresponding to the internal operating state of electronic device 100 or external environmental conditions. In one embodiment, the sensor module 104 may detect the external environment through the first surface 111 of the first housing 110. In one embodiment, the electronic device 100 may include at least one additional sensor module that is disposed to detect the external environment through the second surface 112 of the first housing 110. In one embodiment, sensor module 104 (e.g., an illuminance sensor) may be disposed under first display 130 to detect the external environment through first display 130.In one embodiment, the sensor module 104 may include at least one of the following gesture sensors, gyro sensors, barometric pressure sensors, magnetic sensors, acceleration sensors, grip sensors, color sensors, infrared (IR) sensors, biometric sensors, temperature sensors, humidity sensors, ambient light sensors, proximity sensors, biometric sensors, ultrasonic sensors, or ambient light sensors 104.

According to various embodiments, camera devices 105 and 108 may include a first camera device 105 (e.g., a front camera device) disposed on the first surface 111 of the first housing 110 and a second camera device 108 disposed on the second surface 112 of the first housing 110. In one embodiment, electronic device 100 may further include flash 109 disposed near second camera device 108. In one embodiment, camera devices 105 and 108 may include at least one lens, an image sensor, and/or an image signal processor. In one embodiment, camera devices 105 and 108 may be disposed so that two or more lenses (e.g., a wide-angle lens, an ultra-wide-angle lens, or a telephoto lens) and two or more image sensors are located on one surface of the electronic device 100 (e.g., the first surface 111, the second surface 112, the third surface 121), or the fourth surface 122).In one embodiment, the camera devices 105 and 108 may include lenses and/or image sensors for time of flight (TOF).

According to various embodiments, the keystroke device 106 (e.g., a key button) may be disposed on the third side surface 113c of the first lateral member 113 of the first housing 110. In one embodiment, the keystroke device 106 may be disposed on at least one side surface of the other side surfaces 113a and 113b and/or side surfaces 123a, 123b, and 123c of the second housing 120. In one embodiment, the electronic device 100 may not include some or all of the keystroke devices 106 and the non-contained keystroke device 106 may be implemented in another form, such as a soft key, on the first display 130. In one embodiment, the keystroke device 106 may be implemented using a pressure sensor included in first display 130.

According to various embodiments, some of the camera devices 105 and 108 (e.g., the first camera device 105) or sensor module 104 may be disposed to be exposed through the first display 130. In one embodiment, the first camera device 105 or sensor module 104 may be optically exposed to the outside through an opening (e.g., a through hole) formed at least partially on the first display 130 in the inner space of the electronic device 100. In one embodiment, at least portion of the sensor module 104 may be disposed in the inner space of the electronic device 100 so that it is not visually exposed through the first display 130.

With reference to FIG. 2B, the electronic device 100 may be operated through a hinge device (HA) to maintain at least one specified folding angle in the intermediate state. In such a case, electronic device 100 may control the first display 130 so that different contents are displayed in the display area corresponding to the first surface 111 and the display area corresponding to the third surface 121.In one embodiment, the electronic device 100 may operate in a substantially unfolded state (e.g., the unfolded state of FIG. 1A) and/or in a substantially folded state (e.g., the folded state of FIG. 2A) with respect to a certain folding angle (e.g., the angle between the first housing 110 and the second housing 120when the electronic device 100 is in an intermediate state) through a hinge device (HA). In one embodiment, the electronic device 100 may be operated through a hinge device (HA) to transition to an unfolded state (e.g., the unfolded state of FIG. 1A) when pressurized force is provided in the unfolding direction (A direction) at a certain folding angle. In one embodiment, the electronic device 100 may be operated through a hinge device (HA) in an unfolded state at a certain folding angle, to transition to a folded state (e.g., a folding state of FIG. 2A) if pressing force is provided in the direction to be folded (B direction). In one embodiment, the electronic device 100 may be operated through a hinge device (HA) to maintain an unfolded state (not shown) at various folding angles (free-stop function).

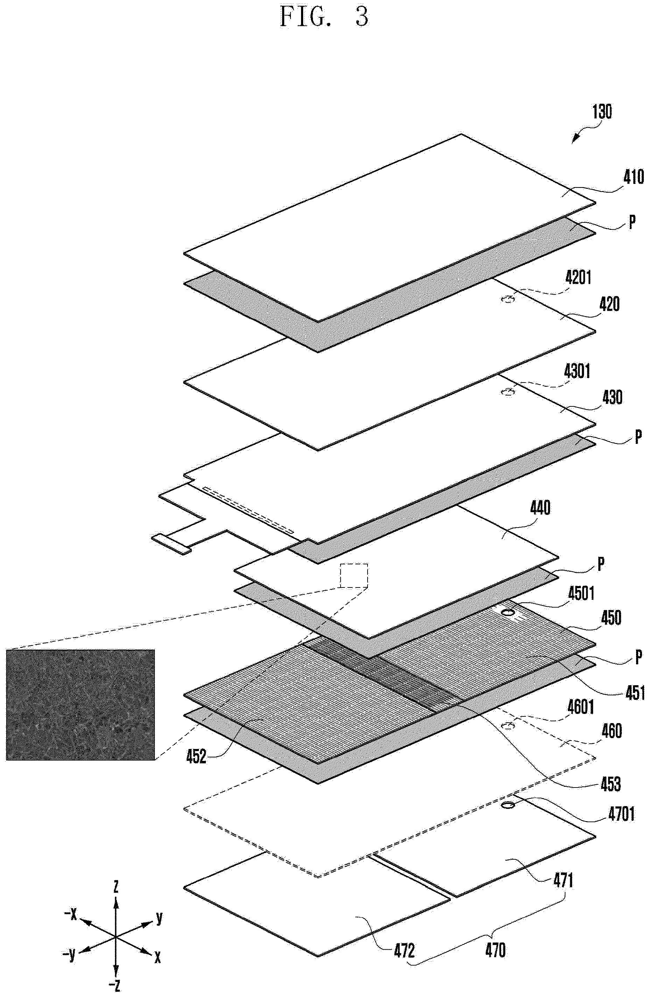

FIG. 3 is an exploded perspective view of a flexible display according to various embodiments of the present disclosure.

A flexible display (e.g., the first display 130 of FIG. 1A) according to exemplary embodiments of the present disclosure may include an unbreakable (UB) type OLED display (e.g., a curved display). However, the display is not limited thereto, and the flexible display 130 may also include an OCTA (on cell touch AMOLED (active matrix organic light-emitting diode)) type flat type display or any other suitable flexible display type.

With reference to FIG. 3, the flexible display 130 (e.g., the first display 130 of FIG. 1A) may include a window layer 410, a polarizer (POL) layer 420 (e.g., a polarizing film) sequentially disposed on a rear surface (e.g., the -z-axis direction) of the window layer 410, a display panel 430, a heat dissipation member 440, a support plate 450, and a reinforcement plate 470. In one embodiment, the display panel 430 may include a polymer layer. In one embodiment, the reinforcement plate 470 may include a first reinforcement plate 471 disposed in a position corresponding to at least a portion of the first housing 110 and a second reinforcement plate 472 disposed in a position corresponding to at least a portion of the second housing 120. In one embodiment, a digitizer 460 disposed between the support plate 450 and the reinforcement plate 470 may also be included. In some embodiments, the digitizer 460 may be separately disposed to correspond to the first housing 110 and the second housing 120, respectively. In some embodiments, the digitizer 460 may be omitted. In one embodiment, at least one of the polarizer layer 420, display panel 430, support plate 450, digitizer 460, or first reinforcement plate 471 may include openings 4201, 4301, 4501, 4601, 4701 that are disposed below it and perforated for at least one optical module (e.g., camera device or sensor module) disposed to detect the external environment through the flexible display 130.

According to various embodiments, the window layer 410 may include a glass layer. In one embodiment, the window layer 410 may include ultra thin glass (UTG) (or foldable thin glass (FTG)). In some embodiments, the window layer 410 may include a polymer. In such cases, the window layer 410 may include polyethylene terephthalate (PET) or polyimide (PI). In some embodiments, the window layer 410 may be disposed in a plurality of layers to include a glass layer and a polymer. In some embodiments, the flexible display 130 may further include a glass layer formed as part of the window layer 410 or a coating layer formed on at least a portion of the top surface, rear surface or side surface of a polymer (e.g., a protective film layer) disposed on top of the glass layer. In such cases, the coating layer may include a hard coating layer (HC layer), an anti reflection/low reflection (AR/LR) coating layer, a shatter proof (SP) coating layer, and/or an anti fingerprint (AF) coating layer. In some embodiments, the coating layer may be formed on at least one of the following portions: between the polymer and the glass layer, on a side surface of the polymer, or on the rear surface or side surface of the glass layer.

According to various embodiments, the window layer 410, polarizer layer 420, display panel 430, heat dissipation member 440, and support plate 450 may be disposed to cross at least a portion of a first surface (e.g., first surface 211 in FIG. 1A) of the first housing (e.g., first housing 110 in FIG. 1A) and a third surface (e.g., third surface 221 in FIG. 1A) of the second housing (e.g., second housing 220 in FIG. 1A). In one embodiment, the reinforcement plate 470 may provide rigidity for the flexible display 130 and may be used as a ground to prevent or reduce malfunction of the flexible display 130. In one embodiment, the window layer 410, the polarizer layer 420, the display panel 430, the heat dissipation member 440, the support plate 450, and the reinforcement plate 470 may be attached to each other through an adhesive member (or adhesive) P. For example, the adhesive member may include at least one of an optical clear adhesive (OCA), a pressure sensitive adhesive (PSA), a heat-reactive adhesive, a general adhesive, or a double-sided tape.

According to various embodiments, the display panel 430 may include a plurality of pixels and a wiring structure (e.g., an electrode pattern). In one embodiment, the display panel 430 may further include a polymer layer disposed below it. In one embodiment, the polymer layer may be disposed below the display panel 430 to provide a dark background for visibility of the display panel 430, and may be formed of a cushioning material for cushioning. In some embodiments, the polymer layer may be removed or disposed under the support plate 450 to waterproof the flexible display 130. In some embodiments, the polymer layer may be omitted if the support plate 450 and/or the heat dissipation member 440 is formed of an opaque material. In one embodiment, the polarizer layer 420 may selectively pass light that is generated from a light source on the display panel 430 and oscillates in a certain direction. In one embodiment, the display panel 430 and the polarizer layer 420 may be integrally formed. In one embodiment, the flexible display 130 may include a touch panel (not shown).

According to various embodiments, the support plate 450 may provide flexural properties to the flexible display 130. For example, the support plate 450 may be formed of a non-metallic, thin sheet material, such as fiber reinforced plastics (FRP) (e.g., carbon fiber reinforced plastics (CFRP) or glass fiber reinforced plastics (GFRP)) that has rigid properties for supporting the display panel 430. In one embodiment, the support plate 450 may include a first flat surface portion 451 corresponding to a first housing (e.g., first housing 110 in FIG. 1A), a second flat surface portion 452 corresponding to a second housing (e.g., second housing 220 in FIG. 1A), and a flexible portion 453 (flexible portion or bending portion) connecting the first flat surface portion 451 and the second flat surface portion 452. In one embodiment, the flexible portion 453 may be formed to have a pattern (e.g., a plurality of openings and/or recesses) for improved flexibility. In some embodiments, the support plate 450 may be formed of a metallic material such as steel use stainless (SUS) (e.g., STS (stainless steel)), Cu, Al, or metallic CLAD (e.g., a laminated member with alternating layers of SUS and Al). In one embodiment, the support plate 450 may be used to help reinforce the rigidity of the electronic device (e.g., electronic device 100 of FIG. 1A), shield ambient noise, and dissipate heat emitted from nearby heat-emitting components.

According to various embodiments, the heat dissipation member 440 may be disposed between two structures of the electronic device (e.g. the display panel 430 and the support plate 450), at least partially overlapping a folding area of the flexible display 130 (e.g., the third area 130c in FIG. 1A), and bendable together with the flexible display 130. In some embodiments, the heat dissipation member 440 may have a high thermal conductivity through a composite composition containing a carbon fiber, a thermally conductive wire and an elastomer, and may be composed of a heat-conducting network that is stretchable, so that the placement of the heat dissipation member can be considered and can be flexibly applied to areas requiring deformation or bending, without structural changes that impede the slimming of the electronic device. In one embodiment, the heat dissipation member 440 may be advantageous to manufacture because the heat transfer direction is determined through a float assembly method after stirring carbon fibers, thermally conductive wires, and elastomers stirred through an organic solvent including dimethylformamide (N,N-dimethylmethanamide, DMF) and decamethylcyclopentasiloxane (D5) in a specified mixing ratio. In one embodiment, the heat dissipation member 440 may be formed to be elastically resilient through the polymeric film, so that it can be adaptively applied to that portion of the electronic device that is subject to structural changes (e.g., bending or folding) without breakage or permanent deformation.

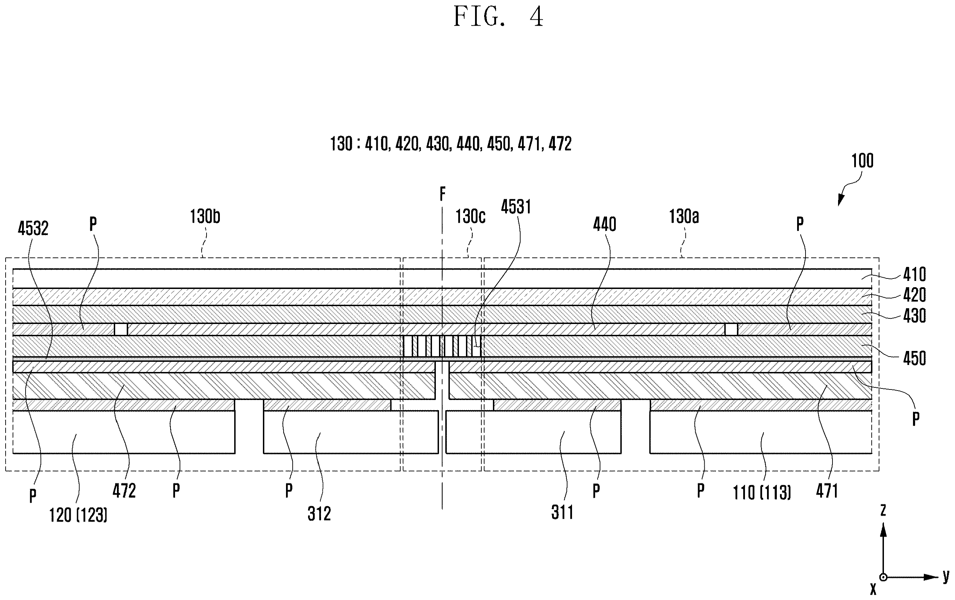

FIG. 4 is a partial cross-sectional view of an electronic device viewed along the line 4-4 of FIG. 1A according to various embodiments of the present disclosure.

The electronic device 100 comprises a heat dissipation member 440, a first structure (e.g. a first housing **110),** and a second structure (e.g. a second housing 120) spaced apart from the first structure. The heat dissipation member 440 is configured to thermally connect the first structure and the second structure. That is, the heat dissipation member may be connected to the first structure and the second structure such that heat may move between the first structure and the second structure via the heat dissipation member.

The heat dissipation member 440 comprises carbon fibers aligned to be at least partially oriented, thermally conductive wires configured to thermally interconnect at least some of the carbon fibers (i.e. the thermally conductive wires connect carbon fibers to each other such that heat can be transferred between the connected carbon fibers via the thermally conductive wires), and a polymer film configured to at least partially coat the carbon fibers and the thermally conductive wires.

With reference to FIG. 4, the electronic device 100 may include a first housing 110 including a first lateral member 113, a second housing 120 including a second lateral member 123, and a flexible display 130 disposed to be supported by the first housing 110 and the second housing 120. In one embodiment, the flexible display 130 may be disposed to be supported, at least in part, by a first hinge plate (e.g., a first wing plate) coupled to the first housing and a second hinge plate (e.g., a second wing plate) coupled to the second housing. In one embodiment, the first hinge plate 311 and the second hinge plate 312 may be disposed to support a portion of the rear surface of the flexible display 130 such that, when the electronic device 100 is in a folded state, the folding area 130c of the flexible display 130 has a defined bending shape (e.g., water droplet shape). In one embodiment, when the electronic device 100 is in the unfolded state, the first housing 110, the first hinge plate 311, the second housing 120, and the second hinge plate 312 may form substantially the same plane to support the flexible display 130.

According to various embodiments, the flexible display 130 may include a first area 130a (e.g., a first flat area) corresponding to at least a portion of the first housing 110, a second area 130b (e.g., a second flat area) corresponding to at least a portion of the second housing 120, and a third area 130c (e.g., a folding area) connecting the first area 130a and the second area 130b and disposed bendably about the folding axis F. In one embodiment, the flexible display 130 may include a window layer 410, a polarizer layer 420 disposed sequentially below the window layer 410, a display panel 430, the heat dissipation member 440, a support plate 450, and reinforcement plates 471 and 472. In one embodiment, the support plate 450 may include a pattern 4531 including at least one opening formed at specified intervals in the folding area 130c to provide flexibility to the flexible display 130. In some embodiments, the pattern 4531 may include at least one recess formed lower than the outer surface. In one embodiment, the flexible display 130 may include a blocking member 4532 disposed below the support plate 450, at least in an area corresponding to the folding area 130c, and disposed to block the plurality of openings in the pattern 4531. In one embodiment, the blocking member 4532 may include a thermoplastic polyurethane (TPU) attached to the support plate 450. In one embodiment, the reinforcement plates 471 and 472 may include a first reinforcement plate 471 disposed below the support plate 450 in an area corresponding to at least a portion of the first housing 110 and a second reinforcement plate 472 disposed below the support plate 450 in an area corresponding to at least a portion of the second housing 120.

According to various embodiments, the heat dissipation member 440 may be disposed between the display panel 430 and the support plate 450, from at least a portion of the first area 130a, across the third area 130c, to at least a portion of the second area 130b. For example, when the flexible display 130 is folded about the folding axis F, the heat dissipation member 440 may also be bent together. In one embodiment, the heat dissipation member 440 may be disposed such that the collected heat is moved from the first area 130a to the second area 130b in a direction (e.g., the -y axis direction) or from the second area 130b to the first area 130a in a direction (e.g., the y axis direction). In one embodiment, the heat dissipation member may be stretched (e.g., deformed) in a specified direction (e.g., ±y axis direction) and with a specified amount of stretch when bent with the flexible display, and may still be formed to have good thermal conductivity. In one embodiment, the heat dissipation member 440 may be configured to have a thermal conductivity of about 700 W/mK or greater. In one embodiment, the heat dissipation member 440 may be configured to have an elongation of about 14% or more. In one embodiment, the heat dissipation member 440 may be restored to its original state when the flexible display 130 is folded to the unfolded state, such that no permanent deformation is caused by bending. This may mean that the placement design of conventional electronics, which must make room for the permanently deformed portion of the heat dissipation member 440, does not need to be considered, and may help slim down the electronic device 100. The heat dissipation member 440 is not limited to being disposed between the display panel 430 and the support plate 450, and may be disposed elsewhere in the electronic device 100. For example, in some embodiments, the heat dissipation member 440 may be disposed between the support plate 450 and the reinforcement plates 471 and 472. For example, in some embodiments, the heat dissipation member 440 may be disposed between the reinforcement plates 471 and 472 and the housings 110 and 130.

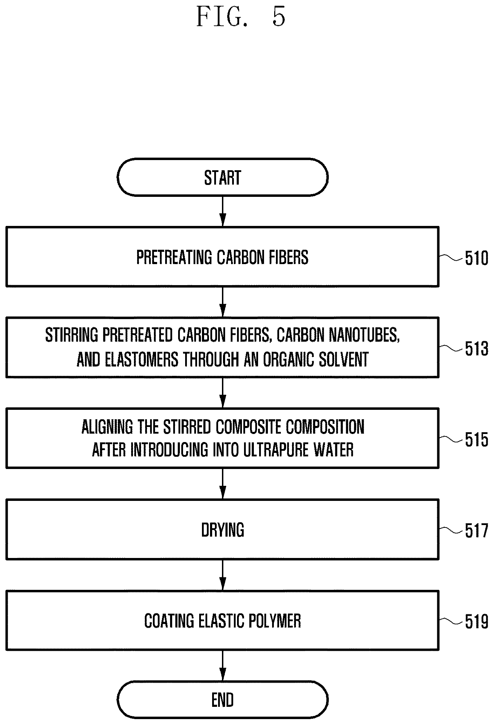

FIG. 5 is a process diagram illustrating a sequence for manufacturing a heat dissipation member according to various embodiments of the present disclosure.

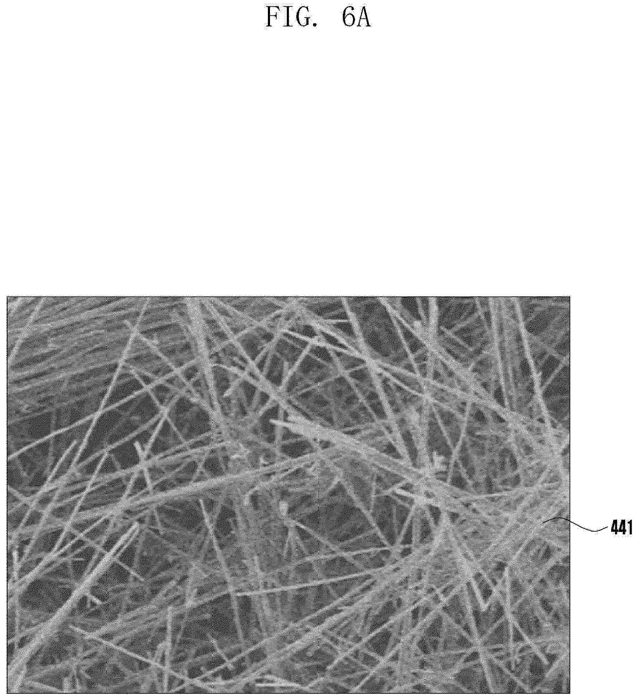

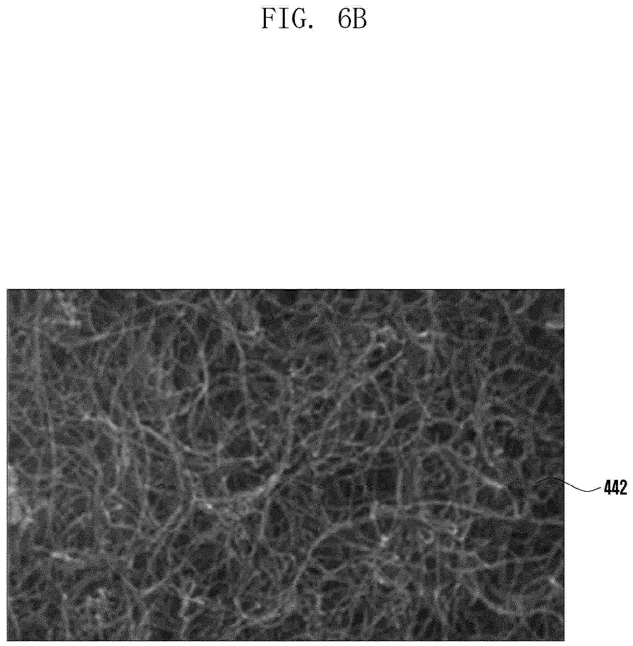

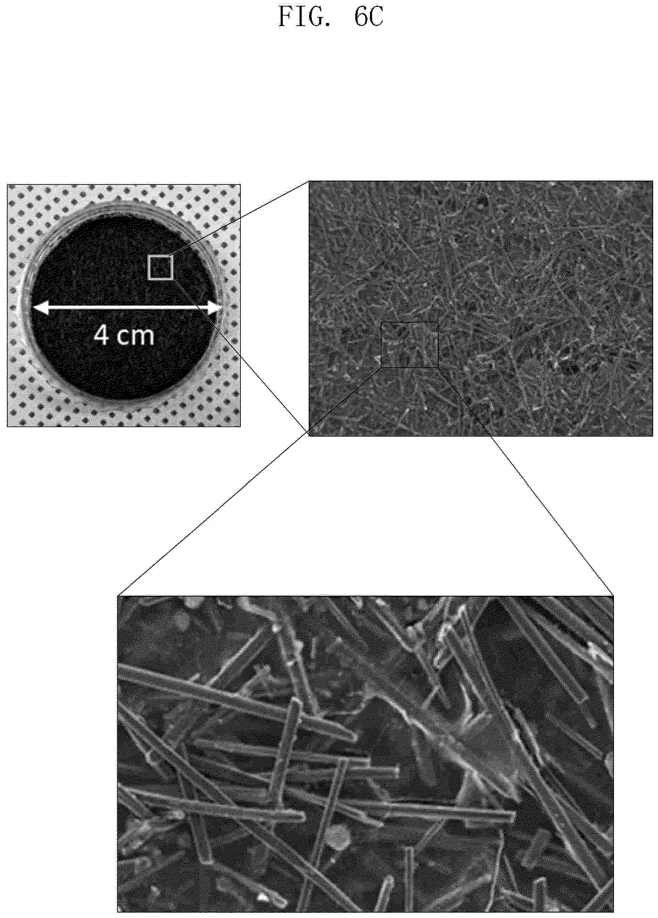

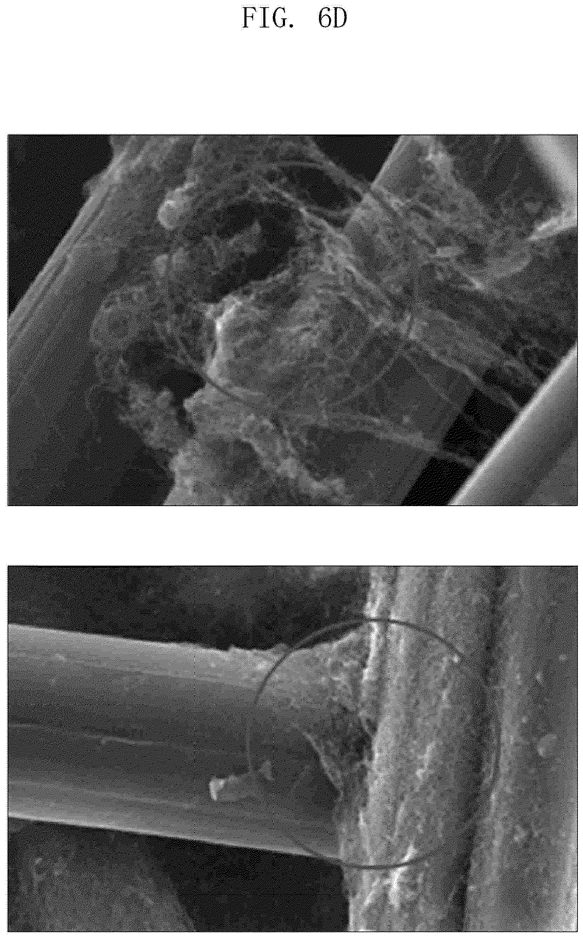

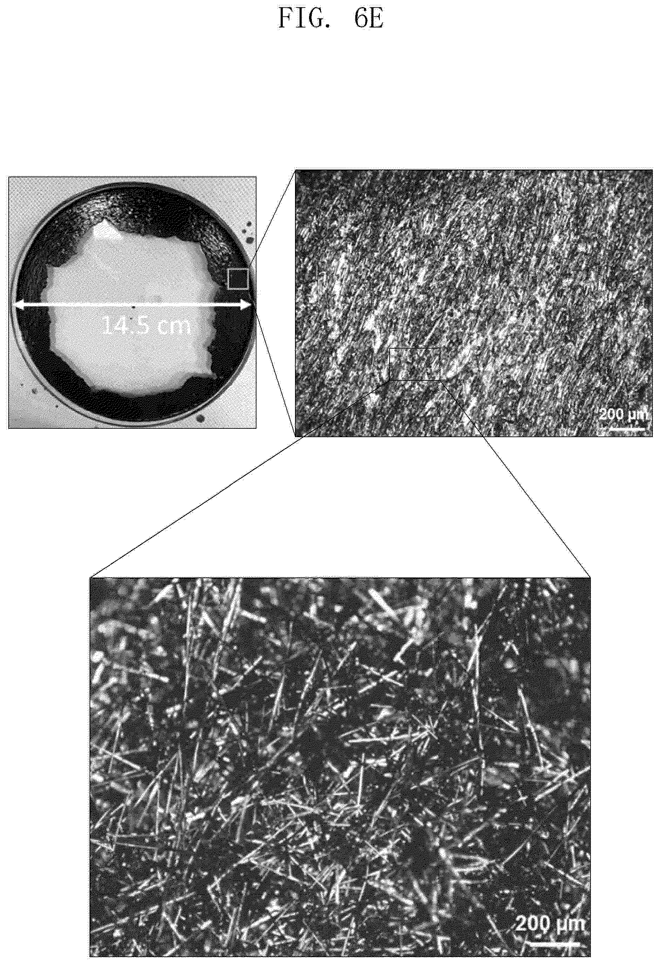

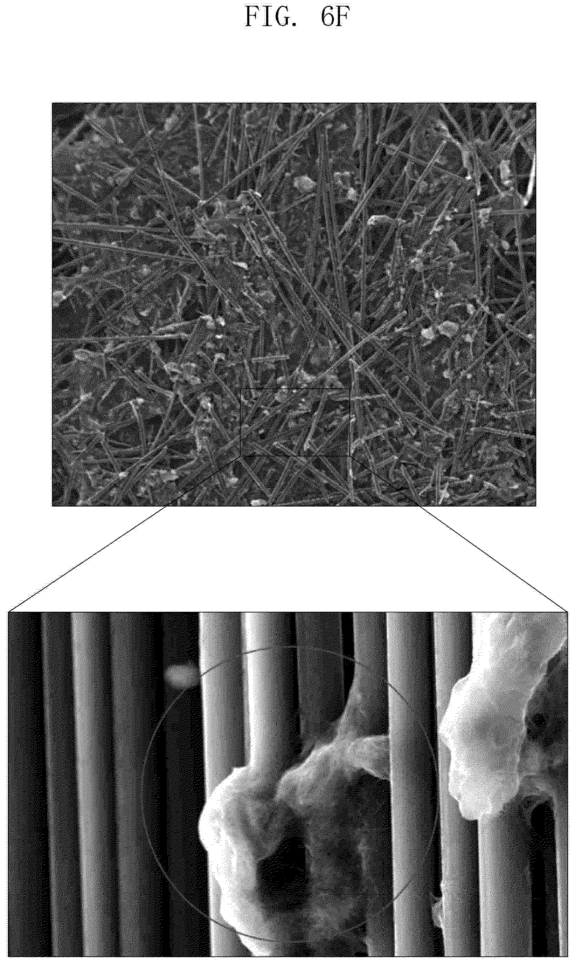

FIG. 6A is an enlarged photograph of a carbon fiber according to various embodiments of the present disclosure. FIG. 6B is an enlarged photograph of a carbon nanotube according to various embodiments of the present disclosure. FIG. 6C is an enlarged photograph of stirred carbon fibers and carbon nanotubes according to various embodiments of the present disclosure. FIG. 6D is an enlarged photograph of a connection structure between carbon fibers through carbon nanotubes according to various embodiments of the present disclosure. FIG. 6E is a photograph of a state in which a composite composition is aligned through a surfactant according to various embodiments of the present disclosure. FIG. 6F is an enlarged photograph of a connection structure between carbon fibers through silver nanowires according to various embodiments of the present disclosure.

The method of manufacturing the heat dissipation member comprises introducing a composite composition containing carbon fibers, thermally conductive wires, and elastomers into an organic solvent, followed by stirring; introducing the stirred composite composition into ultrapure water, followed by water phase alignment; and drying the water phase aligned composite composition and then coating the dried water phase aligned composite composition with an elastic polymer.

At least some of the carbon fibers may have different lengths. For example, the composite composition may comprise carbon fibers of a first length (or range of lengths), and carbon fibers of a second length (or range of lengths), different to the first length (or range of lengths). It will be appreciated that this is merely an example, and that more than two different lengths (or length ranges) of carbon fiber may be included.

Although parts of the detailed description of FIG. 5 below refer to carbon nanotubes and/or silver nanowires, it will be appreciated that these are merely examples, and that the same method may be used for other types of thermally conductive wires (e.g. other metal nanowires).

With reference to FIGS. 5 to FIG. 6F, the method of manufacturing the heat dissipation member 440 may include a first operation 510 (e.g., first process) of pretreating carbon fibers, a second operation 513 (e.g., second process) of stirring the pretreated carbon fibers, thermally conductive wires (e.g. carbon nanotubes and/or silver nanowires), and (optionally) elastomers in an organic solvent, a third operation 515 (e.g., third process) of aligning the stirred composite composition after introducing into ultrapure water, a fourth operation 517 (e.g., fourth process) of drying the aligned composite composition, and a fifth operation 519 (e.g., fifth process) of forming a polymer film on the dried composite composition.

Hereinafter, each operation (e.g., process) will be described in detail.

### ) Carbon fiber pretreatment

According to various embodiments, the carbon fibers 441 shown in FIG.6A may be pretreated prior to processing for manufacturing the heat dissipation member 440. For example, the carbon fibers 441 may be surface treated prior to introducing the composite composition. The surface treatment may comprise silane coating or plasma treatment, for example. In one embodiment, the carbon fiber may have a silane coating such as aminopropyl triethoxysilane (APTES), applied to its surface for effective filling of the carbon nanotubes 442 and/or silver nanowires shown in FIG.6B, within the structure of the carbon fiber 441. In one embodiment, such a silane coating may improve surface adhesion of the carbon fiber 441. For example, silanes (e.g., inorganic compounds having SiH4) have a strong propensity to interact with transition metals (e.g., gold, silver, etc.) due to the polarization of the molecule caused by the difference in electronegativity between silicon (Si) and hydrogen (H), while at the same time, silicon (Si) has an electronic structure similar to carbon (C), which can induce the formation of complexes with stable chemical bonds on the surface of carbon fiber 441. The complexes thus formed may not only increase the surface energy by itself, but also help form a uniform surface layer to increase the physical contact area with other materials, and may cause strong interactions between other materials. For this reason, silane-coated carbon fibers may improve the force of mixing with the elastomer, carbon nanotubes 442 and/or silver nanowires, such that the maximum fill ratio can be improved to 80% by volume and 90% by mass, while simultaneously reducing the viscosity of the resin to a relatively low level, which can help improve the productivity of the heat dissipation member (e.g., carbon composite structure).

According to various embodiments, another method for effective filling of the carbon nanotubes 442 and/or silver nanowires within the carbon fiber 441 may include surface treatment through plasma methods. In one embodiment, plasma (O2) treatment of the carbon fibers 441 through reactive ion etching may help induce or create COO- and CO- functional groups on the surface, which enhance the surface energy, thereby improving the dispersibility of the carbon nanotubes 442 or silver nanowires into the voids within the entangled structure of the carbon fibers, which can help increase the filling rate. As a result, the maximum filling ratio may be improved to 80% by volume and 90% by mass. Furthermore, the functional groups formed on the surface of the carbon fiber 441 through plasma treatment may improve the thermal conductivity by creating a strong interconnecting surface with the dispersed material, as well as increasing the surface roughness to increase the interfacial contact area and phonon bonding with the elastomer, which may also improve the thermal conductivity. Accordingly, it may be possible to produce a composite network structure of a heat dissipation member including carbon fibers, carbon nanotubes, and/or silver nanowires with a certain amount of carbon nanotubes in the network structure, resulting in a lower production cost.

According to various embodiments, the thermal conductivity of the networked structure of the heat dissipation member including only rope-shaped carbon fibers 441 may be calculated to be about 0.78 filling rate due to the nature of the material shape, even if the rope-shaped carbon fibers are arranged in the exemplary float assembly method of the present disclosure, with a filling rate of less than 1 per unit volume, which can significantly reduce the heat transfer efficiency to about 22% due to the reduction in heat transfer area.

According to an exemplary embodiment of the present disclosure, the filling rate may also be adjusted to increase the heat transfer efficiency of the heat dissipation member 440. For example, carbon nanotubes 442 having a high thermal conductivity of about 3000 W/mK and a diameter of several nm (for example, diameters in the range 1-10 nm) may be used to at least partially fill the voids present in the network structure including carbon fibers having a diameter of several µm (for example, diameters in the range 1-10 µm). In one embodiment, the carbon nanotubes 442 may have a strong tendency to bond to each other due to van der Waals forces between them, which by themselves may not fill the voids in a network structure composed of carbon fibers as efficiently as possible. Therefore, the aggregated carbon nanotubes 442 may be introduced into an organic solvent, then evenly dispersed through sonication, then introduced into an organic solvent in which carbon fibers are present (e.g., a mixture of DMF and D5), and filled into the voids in the network structure. In one embodiment, the addition of the carbon nanotubes 442 can help improve the heat transfer efficiency of the heat dissipation member 440, not only by improving the fill rate, but also because they act as heat transfer bridges between the carbon fibers 441, as shown in FIG. 6D.

Stirring of carbon fibers, carbon nanotubes, and elastomers through organic solvents

According to various embodiments, a composite composition including a mixture of carbon fibers, carbon nanotubes, and (optionally) elastomers in certain proportions may be introduced into a container containing an organic solvent and then stirred. In this case, the composition including carbon fibers and carbon nanotubes may range from about 20% to 50% of the total composite composition. In one embodiment, the degree of alignment within the carbon fibers may be a dominant factor in heat transport within the network structure. To enhance the heat transport properties, the carbon fibers may be aligned with respect to each other so as to be at least partially oriented (i.e. so as to at least be not completely randomly oriented). The carbon fibers may be (at least partially) aligned to have orientation along the heat transfer direction of the heat dissipation member. According to exemplary embodiments of the present disclosure, the degree of alignment of the carbon fibers may be controlled by utilizing a float assembly method (water phase alignment) utilizing the Marangoni effect. The water phase alignment may comprise introducing a surfactant into the stirred composite composition floating in the ultrapure water. In one embodiment, the organic solvent may include a mixed solution of a polar solvent, N,N-dimethylmethanamide (DMF), and a non-polar solvent, decamethylcyclopentasiloxane (D5), in a 1:x (1<x<3) ratio, respectively. The unequal mixing ratios of DMF and D5 may help prevent perfect alignment of the carbon fibers, thereby helping to maintain the heat spreading path. In one embodiment, as shown in FIG. 6C, the carbon fibers, carbon nanotubes, and elastomers may be introduced into an organic solvent containing a suitable mixture of DMF and D5, and then be stirred initially using a physical method.

According to various embodiments, DMF may be a highly polar solvent and contain various functional groups, such as amines, aldehydes or alcohols, which are polar in their molecular structure, and therefore may have a very strong tendency to adsorb on the surface of materials and induce high dispersibility by preventing intermolecular deposition after adsorption on the surface. In particular, the molecules of DMF may have a very high affinity and adsorption to carbon-based materials because they form bonds on the surface of carbon-based materials by various interactions such as hydrogen, benzene ring, or benzamide bonds. In addition, DMF may have excellent isomeric stability, which means that it has the ability not only to strongly interact with natural organic pollutants and dissolve them, but also to remain chemically stable during the dissolution of natural organic pollutants. Therefore, DMF may be an optimal solvent to be used during the process of forming heat dissipation members (e.g., carbon composites) due to its high dispersibility and surface adsorption with carbon fibers.

According to various embodiments, D5 may interact with the elastomer to improve its dispersibility and induce improvements in the properties of the elastomer itself. In one embodiment, D5 may include a variety of functional groups, such as silanol, carbonyl, or alkyl groups in the molecule, which may be advantageous for interacting with the elastomer by forming attraction and hydrogen bonds with the elastomer. For example, the relatively small molecular size of D5 may easily penetrate between the molecules of the elastomer, which can form intermolecular interactions in the flexible polymer structure of the elastomer to improve its own properties, as well as increase the adhesion of the elastomer present on the surface to make the surface smooth. In addition, D5 may have a 2-5 centistokes viscosity (1 centistokes in water), which provides adequate fluidity, which can reduce the surface defects or roughness of the elastomer and facilitate processing. In one embodiment, an appropriate degree of alignment of the carbon fibers may be required because if the carbon fibers were perfectly aligned, the heat spreading path would be eliminated due to the absence of contact area during ductility. For this reason, a D5 having a suitable viscosity may be advantageous in facilitating control of the degree of alignment of the carbon fibers. In some embodiments, DMF may be replaced by ethanol or pyridine. In some embodiments, D5 may be replaced by toluene.

### Sorting

According to various embodiments, the carbon composition including carbon fibers, carbon nanotubes, and elastomers introduced into an organic solvent containing DMF and D5 in a certain proportion may be dispersed once again evenly for a second time (second stirring) by sonication for 6 hours. In one embodiment, the sonication time may be configured to be up to 6 hours to prevent destruction of the carbon fibers and carbon nanotubes.

According to various embodiments, a mixed solution including the composite composition stirred through DMF and D5 may be introduced over the entire surface of the deionized water as a solvent. In one embodiment, the mixed solution may be introduced at a rate suitable for even distribution. For example, the rate of introduction of the mixed solution may include about 24 ml/min. Thereafter, when a surfactant (for example, octylphenoxypolyethoxyethanol or other detergent) is introduced to the center of the interface evenly distributed on the surface of the mixed solution, the carbon fibers and carbon nanotubes present throughout the interface may gradually flow and accumulate with a certain degree of orientation at the outer edge of the interface due to the difference in surface tension between the center of the interface and the outer edge, as shown in FIG. 6E. The surfactant added at this time may be important in terms of concentration relative to the solvent, as it is the driving force that creates the surface tension difference at the interface and causes the carbon fibers to flow across the interface. In one embodiment, the effectiveness may increase to a certain degree as the concentration of surfactant relative to the solvent increases, but excessive concentrations will compromise stability, so surfactant may be added at a concentration of 0.1% relative to the solvent (e.g., ultrapure water) every two seconds.

### Drying

Properly aligned carbon compositions through surfactants may be dried at room temperature and may enable to produce a heat dissipation member (e.g., a heat dissipation sheet) having a network structure with a deliberately controlled direction of heat transfer by adjusting the alignment of the carbon fibers within the existing network structure by a certain amount.

### Elastic polymer film formation

Since the heat dissipation members (e.g., heat dissipation sheets) according to various embodiments are carbon fibers as the main skeleton of all network structures, when stretching properties are required, stretching of the structure may occur as the bent or intertwined carbon fibers are stretched or moved in the stretching direction. This is not an elastic behavior, but rather a simple flow of carbon fibers within the structure, which may not be able to self-restore after stretching. Therefore, the manufactured heat dissipation member (e.g., heat dissipation sheet) may be coated (or at least partially coated) with a polymeric film, such as polydimethyl siloxane (PDMS) or polyurethane, that exhibits elastic behavior on the surface of the network structure. In one embodiment, the coated polymer films may be subjected to different heat processing temperatures depending on their thickness or type, but mechanical properties may be controlled by heat treatment typically below 250 degrees, and various coating methods such as spin, spray, or brush may be applied to facilitate controllable thickness of uniform and thin polymer films.

### Substitution of carbon nanotubes

According to various embodiments, carbon nanotubes are complex to manufacture and are formed at high temperatures, resulting in complex processes and high production costs. Therefore, metal nanowires may be used as a material that can perform the same role (i.e. may act as thermally conductive wires) and therefore can at least partially replace the carbon nanotubes in the heat dissipation member described above. In one embodiment, the metal nanowires may include silver-nanowires, which have high thermal conductivity. For example, the silver nanowires may have an approximate diameter size of 100 nm or less, as shown in FIG. 6F. The silver nanowires may serve as a thermal bridge between the carbon fibers. In one embodiment, the silver nanowires may have a high thermal conductivity of 429 W/mK due to the high density of free electrons inside, which activates heat transfer by electron-electron interaction, which is one of the main factors of heat transfer, and may have the property of maintaining the high thermal conductivity for a long time because the oxidation rate is very slow and a very stable oxide on the surface is formed. Therefore, carbon nanotubes and silver nanowires may be used in a certain proportion as materials that can act as thermally conductive wires and maximize heat transfer efficiency through the filling rate of the network structure of the heat dissipation member composed of carbon fibers and acting as heat transfer bridges. That is, the heat dissipation member may comprise thermally conductive wires. The thermally conductive wires may comprise carbon nanotubes and/or metal (e.g. silver) nanowires. In some embodiments, carbon nanotubes may be replaced partially or entirely by silver nanowires.

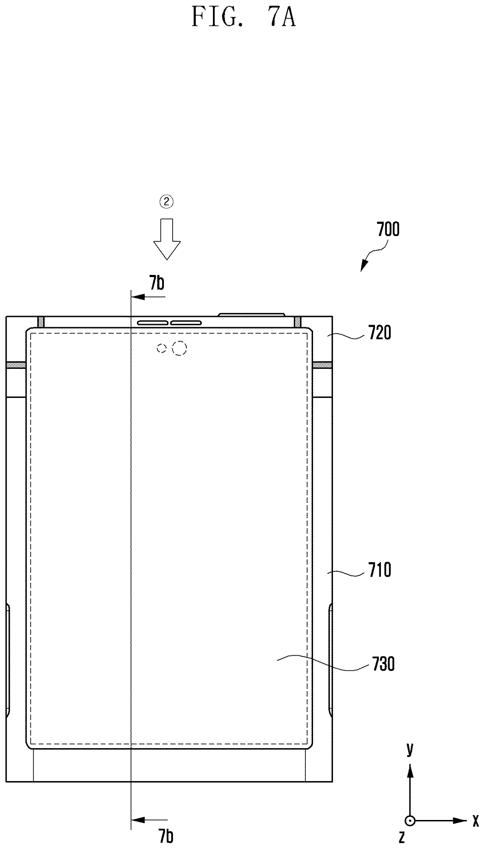

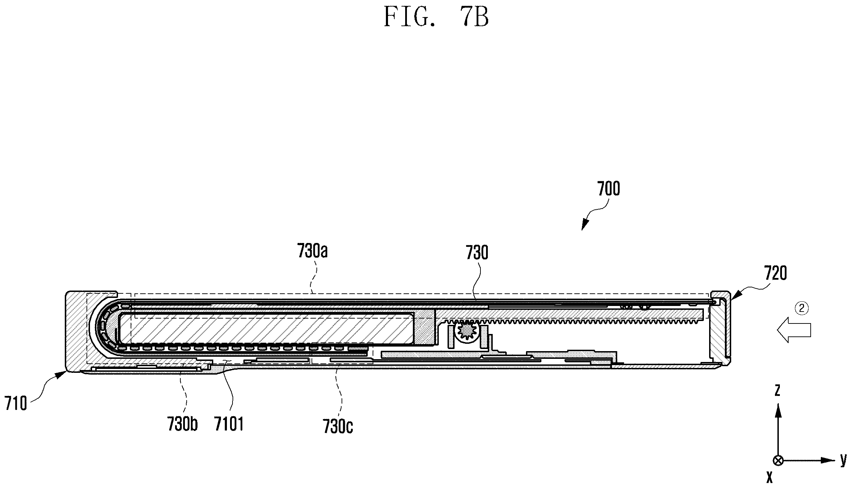

FIG. 7A is a plan view of an electronic device in a slide-in state according to various embodiments of the present disclosure. FIG. 7B is a cross-sectional view of an electronic device viewed along the line 7b-7b of FIG. 7a according to various embodiments of the present disclosure.

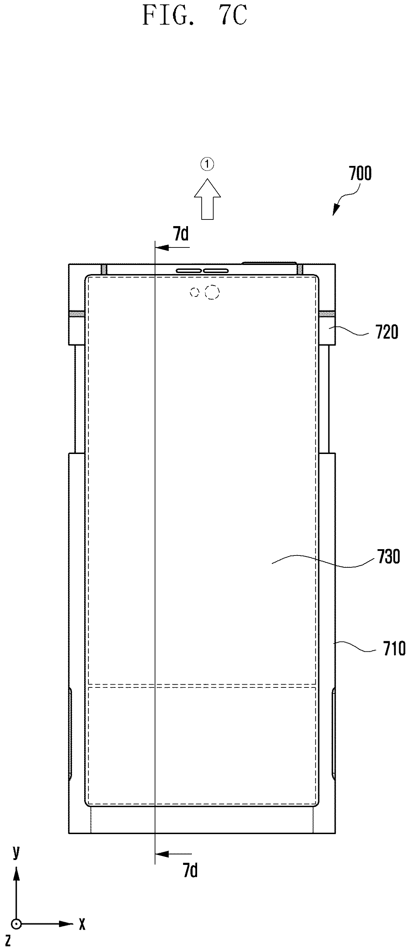

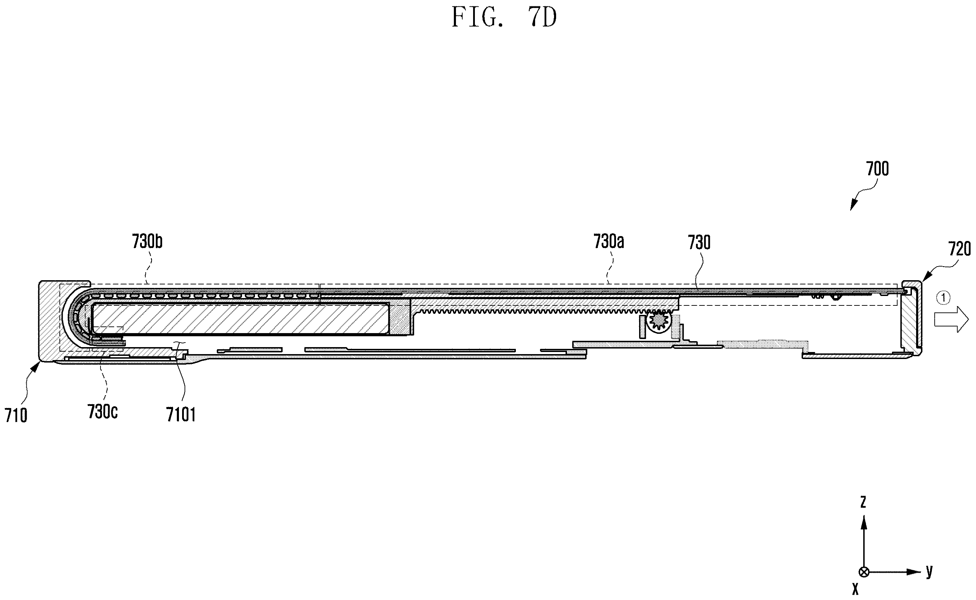

FIG. 7C is a plan view of an electronic device in a slide-out state according to various embodiments of the present disclosure. FIG. 7D is a cross-sectional view of an electronic device viewed along the line 7d-7d of FIG. 7c according to various embodiments of the present disclosure.

With reference to FIGS. 7A to 7D, the electronic device 700 may include a first housing 710 and a second housing 720 slidably coupled to the first housing 710 in a specified direction and a specified reciprocating distance from the first housing 710. The second housing 720 may be slidably coupled to the first housing 710 such that the electronic device 700 can be converted between a slide-in state and a slide-out state. In one embodiment, the electronic device 700 **may include** a flexible display 730 that is fixed to at least a portion of the second housing 720 and that slides into or out of the inner space 7101 of the first housing 710 in response to a sliding motion of the second housing 720, thereby varying the display area. For example, the flexible display 730 may have a first display area when the second housing 720 is slid out from the first housing 710 in a first direction (e.g., direction ①). In one embodiment, the flexible display 730 may have a second display area that is smaller than the first display area, with the second housing 720 slid in a second direction (e.g., direction ②) opposite the first direction (e.g., direction ①).

According to various embodiments, the flexible display 730 may include a first flat surface portion 730a that is fixed to the second housing 720, a bending portion 730b that extends from the first flat surface portion 730a, is externally visible in a slide out state, and is not externally visible in a slide in state by being slid into the inner space 7101 of the first housing through a bending motion, and a second flat surface portion 730c that extends from the bending portion 730b, is not exposed to the outside all the time, and is positioned in the inner space 7101 of the first housing 710.

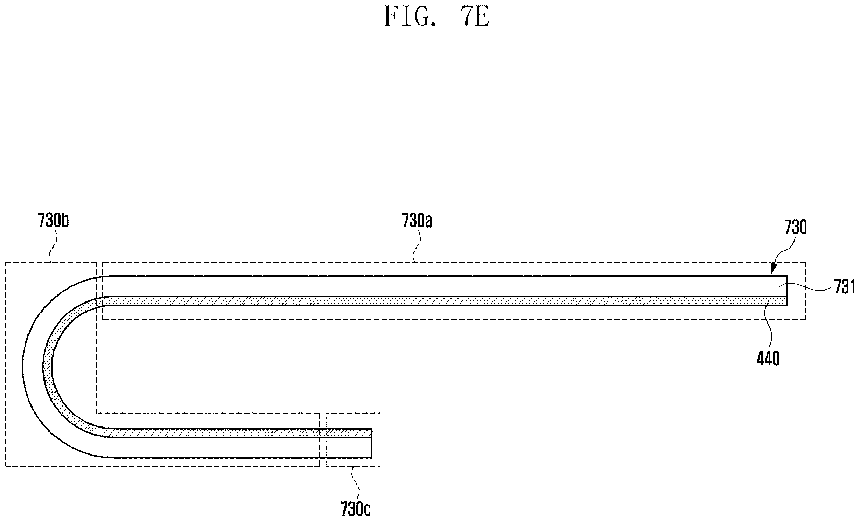

FIG. 7E is a schematic diagram of a flexible display with a heat dissipation member disposed according to various embodiments of the present disclosure.

With reference to FIG. 7E, the flexible display 730 may include a heat dissipation member 440 (e.g., the heat dissipation member 440 of FIG. 7) disposed in a manner that attaches to a rear surface of the display panel 731. In one embodiment, the heat dissipation member 440 may deform in a bendable manner with the display panel 731 when the electronic device 700 transitions from the slide in state to the slide out state, or from the slide out state to the slide in state. In one embodiment, the heat dissipation member 440 may have a high thermal conductivity through a composite composition containing carbon fibers, thermally conductive wires, and elastomers and may be constituted as a stretchable heat-conducting network, thereby performing a heat dissipation function with a high thermal conductivity in the inner space of the electronic device 700, and being flexibly bent together with the display panel 730 of the flexible display.

According to various embodiments (e.g. a first example embodiment), an electronic device may include a first structure (e.g., the first housing 110 of FIG. 4, or a portion of an inner space of the first housing), a second structure (e.g., the second housing 120 of FIG. 4, or a portion of an inner space of the second housing) spaced apart from the first structure, and a heat dissipation member (e.g., the heat dissipation member 440 of FIG. 4) thermally connected to the first structure and the second structure, wherein the heat dissipation member may include carbon fibers (e.g., carbon fibers 441 of FIG. 6A) aligned to be at least partially oriented, thermally conductive wires at least partially thermally connecting the carbon fibers (e.g., carbon nanotubes 442 of FIG. 6B), and a polymer film at least partially coated on the carbon fibers and the thermally conductive wires.

According to various embodiments (e.g. a second example embodiment based on the first example embodiment), the thermally conductive wires may include at least one of silver nanowires or carbon nanotubes.

According to various embodiments (e.g. a third example embodiment based on the first or second example embodiments), at least some of the carbon fibers may have different lengths.

According to various embodiments (e.g. a fourth example embodiment based on any of the first to third example embodiments), the carbon fibers may include a silane coated coating layer.

According to various embodiments (e.g. a fifth example embodiment based on any of the first to third example embodiments), the polymer film may include at least one of polydimethyl siloxane (PDMS) or polyurethane.

According to various embodiments (e.g. a sixth example embodiment based on any of the first to fifth example embodiments), the carbon fibers may be aligned to have the orientation along a heat transfer direction of the heat dissipation member.

According to various embodiments (e.g. a seventh example embodiment), a first housing (e.g., the first housing 110 of FIG. 4), a second housing (e.g., the second housing 120 of FIG. 4) foldably connected to the first housing through a hinge device (e.g., the hinge device HA of FIG. 1B), and a flexible display (e.g., the flexible display 130 of FIG. 4) disposed to be supported by the first housing and the second housing and including a display panel (e.g., the display panel 430 of FIG. 4) may be included, wherein the heat dissipation member (e.g., the heat dissipation member 440 of FIG. 4) may be disposed between the display panel and the first and second housings, and at least a portion of the heat dissipation member may be bendably disposed together with the display panel.

According to various embodiments (e.g. an eighth example embodiment), a first housing (e.g., the first housing 710 of FIG. 7A), a second housing (e.g., the second housing 720 of FIG. 7A) slidably coupled to the first housing, and a flexible display (e.g., the flexible display 731 of FIG. 7A) disposed to be at least partially supported by the second housing, accommodated in a manner such that, in a slide-in state, at least a portion of the display area is bent into the first housing so as to be invisible from the outside, and including a display panel (e.g., the display panel 731 of FIG. 7E), may be included, wherein the heat dissipation member may be disposed on a rear surface of the display panel bendably with the display panel.

According to various embodiments (e.g. a ninth example embodiment), the heat dissipation member may include carbon fibers (e.g., carbon fibers 441 in FIG. 6A) aligned to be at least partially oriented, thermally conductive wires at least partially thermally connecting the carbon fibers (e.g., carbon nanotubes 442 in FIG. 6B), and a polymer film at least partially coated on the carbon fibers and the thermally conductive wires.

According to various embodiments (e.g. a tenth example embodiment based on the ninth example embodiment), the thermally conductive wires may include at least one of silver nanowires or carbon nanotubes.

According to various embodiments (e.g. an eleventh example embodiment based on the ninth or tenth example embodiments), the polymer film may include at least one of polydimethyl siloxane (PDMS) or polyurethane.

According to various embodiments (e.g. a twelfth example embodiment), a method of manufacturing a heat dissipation member may include: introducing a composite composition containing a carbon fiber (e.g., carbon fiber 441 of FIG. 6A), a thermally conductive wire (e.g., carbon nanotube 442 of FIG. 6B), and an elastomer into an organic solvent, followed by stirring; introducing a mixed solution containing the stirred composite composition into ultrapure water, followed by water phase aligning; drying the water phase aligned composite composition; and coating the elastomer.

According to various embodiments (e.g. a thirteenth example embodiment based on the twelfth example embodiment), an operation of surface-treating the carbon fibers may be further included prior to introducing the composite composition.

According to various embodiments (e.g. a fourteenth example embodiment based on the thirteenth example embodiment), the surface-treating may include a silane coating or plasma treatment.

According to various embodiments (e.g. a fifteenth example embodiment based on any of the twelfth to fourteenth example embodiments), an operation of dispersion treatment through the sonication may be further included prior to introducing the composite composition.

According to various embodiments (e.g. a sixteenth example embodiment based on any of the twelfth to fifteenth example embodiments), the organic solvent may include dimethylformamide (N,N-dimethylmethanamide, DMF) and decamethylcyclopentasiloxane (D5) mixed in a specified ratio.

According to various embodiments (e.g. a seventeenth example embodiment based on the sixteenth example embodiment), the mixing ratio of the DMF and the D5 may include a range of 1:x (1<x<3).

According to various embodiments (e.g. an eighteenth example embodiment based on any of the twelfth to seventeenth example embodiments), the stirring operation may be performed in less than 6 hours through ultrasonic stirring.

According to various embodiments (e.g. a nineteenth example embodiment based on any of the twelfth to eighteenth example embodiments), the water phase aligning operation may include introducing a surfactant into a mixed solution containing the composite composition floating in the ultrapure water.

According to various embodiments (e.g. a twentieth example embodiment based on the nineteenth example embodiment), the surfactant may include introducing the surfactant at a concentration of 0.1% relative to the ultrapure water concentration once every two seconds.

In a first example, there is provided a heat dissipation member, comprising: carbon fibers aligned to be at least partially oriented; thermally conductive wires configured to thermally interconnect at least some of the carbon fibers; and a polymer film configured to at least partially coat the carbon fibers and the thermally conductive wires.

In a second example, there is provided the heat dissipation member of the first example, wherein the thermally conductive wires comprise at least one of silver nanowires or carbon nanotubes.

In a third example, there is provided the heat dissipation member of the first or second examples, wherein at least some of the carbon fibers have different lengths.

In a fourth example, there is provided the heat dissipation member of any of the first to third examples, wherein the carbon fibers comprise a silane coating layer.

In a fifth example, there is provided the heat dissipation member of any of the first to fourth examples, wherein the polymer film comprises at least one of polydimethyl siloxane (PDMS) or polyurethane.

In a sixth example, there is provided the heat dissipation member of any of the first to fifth examples, wherein the carbon fibers are aligned to have the orientation along the heat transfer direction of the heat dissipation member.

In a seventh example, there is provided an electronic device comprising: the heat dissipation member of any of the first to sixth examples; a first structure; and a second structure spaced apart from the first structure; wherein the heat dissipation member is configured to thermally connect the first structure and the second structure.

In an eighth example, there is provided the electronic device of the seventh example, further comprising: a first housing; a second housing foldably connected to the first housing through a hinge device; and a flexible display disposed to be supported by the first housing and the second housing and including a display panel, wherein the heat dissipation member is disposed between the display panel and the first and second housings, and at least a part of the heat dissipation member is disposed to be bendable together with the display panel.

In a ninth example, there is provided the electronic device of the seventh example, comprising: a first housing; a second housing slidably coupled to the first housing such that the electronic device can be converted between a slide-in state and a slide-out state; and a flexible display disposed to be at least partially supported by the second housing, accommodated in such a way that, in the slide-in state, at least a portion of the display area of the flexible display is bent inside the first housing so as not to be visible from the outside of the electronic device, and including a display panel, wherein the heat dissipation member is disposed on the rear surface of the display panel to be bendable together with the display panel.

In a tenth example, there is provided a method of manufacturing a heat dissipation member, the method comprising: introducing a composite composition containing carbon fibers and thermally conductive wires into an organic solvent, followed by stirring; introducing the stirred composite composition into ultrapure water, followed by water phase alignment; and drying the water phase aligned composite composition and then coating the dried water phase aligned composite composition with an elastic polymer.

In an eleventh example, there is provided the method of the tenth example, further comprising surface-treating the carbon fibers prior to introducing the composite composition.

In a twelfth example, there is provided the method of the eleventh example, wherein the surface treatment comprises silane coating or plasma treatment.

In a thirteenth example, there is provided the method of any of the tenth to twelfth examples, further comprising at least one of: dispersing the composite composition through sonication prior to introducing the composite composition to the organic solvent; and dispersing the composite composition through sonication after introducing the composite composition to the organic solvent.

In a fourteenth example, there is provided the method of any of the tenth to thirteenth examples, wherein the organic solvent comprises dimethylformamide (N,N-dimethylmethanamide), DMF, and decamethylcyclopentasiloxane, D5, mixed in a specified ratio; and wherein the specified ratio of the DMF and the D5 is a range of 1:x, wherein 1<x<3.

In a fifteenth example, there is provided the method of any of the tenth to fourteenth examples, wherein the water phase alignment comprises introducing a surfactant into the stirred composite composition floating in the ultrapure water.

In addition, the embodiments of the present disclosure disclosed in the specification and drawings are merely provided as specific examples to easily explain the technical content according to the embodiments of the present disclosure and to facilitate the understanding of the embodiments of the present disclosure, but are not intended to limit the scope of the embodiments of the present disclosure. Therefore, the scope of the various embodiments of the present disclosure should be interpreted as including all changes or modifications derived based on the technical idea of the various embodiments of the present disclosure in addition to the embodiments disclosed in the present disclosure.

## Claims

1. A heat dissipation member (440), comprising:
carbon fibers (441) aligned to be at least partially oriented;
thermally conductive wires (442) configured to thermally interconnect at least some of the carbon fibers (441); and
a polymer film configured to at least partially coat the carbon fibers (441) and the thermally conductive wires (442).

2. The heat dissipation member (440) of claim 1, wherein the thermally conductive wires (442) comprise at least one of silver nanowires or carbon nanotubes.

3. The heat dissipation member (440) of claim 1 or 2, wherein at least some of the carbon fibers (441) have different lengths.

4. The heat dissipation member (440) of any one of claims 1 to 3, wherein the carbon fibers (441) comprise a silane coating layer.

5. The heat dissipation member (440) of any one of claims 1 to 4, wherein the polymer film comprises at least one of polydimethyl siloxane (PDMS) or polyurethane.

6. The heat dissipation member (440) of any one of claims 1 to 5, wherein the carbon fibers (441) are aligned to have the orientation along the heat transfer direction of the heat dissipation member (440).

7. An electronic device comprising:
the heat dissipation member (440) of any of claims 1 to 6;
a first structure (110); and
a second structure (120) spaced apart from the first structure (110),
wherein the heat dissipation member (440) is configured to thermally connect the first structure (110) and the second structure (120).

8. The electronic device of claim 7, further comprising:
a first housing (110);
a second housing (120) foldably connected to the first housing (110) through a hinge device (HA); and
a flexible display (130) disposed to be supported by the first housing (110) and the second housing (120) and including a display panel (430), wherein
the heat dissipation member (440) is disposed between the display panel (430) and the first and second housings (110, 120), and
at least a part of the heat dissipation member (440) is disposed to be bendable together with the display panel (430).

9. The electronic device of claim 7, comprising:
a first housing (710);
a second housing (720) slidably coupled to the first housing (710) such that the electronic device can be converted between a slide-in state and a slide-out state; and
a flexible display (730) disposed to be at least partially supported by the second housing (720), accommodated in such a way that, in the slide-in state, at least a portion of the display area of the flexible display (730) is bent inside the first housing (710) so as not to be visible from the outside of the electronic device, and including a display panel (731), wherein
the heat dissipation member (440) is disposed on the rear surface of the display panel (731) to be bendable together with the display panel (731).

10. A method of manufacturing a heat dissipation member (440), the method comprising:
introducing a composite composition containing carbon fibers (441) and thermally conductive wires (442) into an organic solvent, followed by stirring;
introducing the stirred composite composition into ultrapure water, followed by water phase alignment; and
drying the water phase aligned composite composition and then coating the dried water phase aligned composite composition with an elastic polymer.

11. The method of claim 10, further comprising surface-treating the carbon fibers (441) prior to introducing the composite composition.

12. The method of claim 11, wherein the surface treatment comprises silane coating or plasma treatment.

13. The method of any one of claims 10 to 12, further comprising at least one of:
dispersing the composite composition through sonication prior to introducing the composite composition to the organic solvent; and
dispersing the composite composition through sonication after introducing the composite composition to the organic solvent.

14. The method of any one of claims 10 to 13, wherein the organic solvent comprises dimethylformamide (N,N-dimethylmethanamide), DMF, and decamethylcyclopentasiloxane, D5, mixed in a specified ratio; and
wherein the specified ratio of the DMF and the D5 is a range of 1:x, wherein 1<x<3.

15. **16.** The method of any one of claims 10 to 14, wherein the water phase alignment comprises introducing a surfactant into the stirred composite composition floating in the ultrapure water.
